# EUROPEAN PATENT APPLICATION

(11) **EP 3 441 440 A1**
(43) Date of publication of application: **13.02.2019**
(21) Application number: 18158184.4
(22) Date of filing: 22.02.2018
(51) Int. Cl.: C09K 11/02, H01L 33/50, H05B 33/20

(54) **PHASE SEPARATED QUANTUM DOT LAYER WITH STABILIZED QUANTUM DOTS**

(30) Priority: 07.08.2017 US 201715670416
(71) Applicant: SABIC Global Technologies B.V., 4612 PX Bergen op Zoom (NL)
(72) Inventor: HYUN, Soonyoung, 16854 Gyeonggi-do (KR); LEE, Jong Woo, Seoul (KR); BASTWROS, Adell Fawzy, Newburgh, IN Indiana 47630 (US); ZHOU, Hao, Newburgh, IN Indiana 47630 (US)
(74) Representative: Elzaburu S.L.P.

(57) **Abstract**

Composition and films for light emitting devices are disclosed. An example film may comprise at least one polymer layer comprising a first polymer and a second polymer. The second polymer may exhibit partial miscibility with respect to the first polymer. The partial miscibility of the first polymer relative to the second polymer may be greater than 0% miscibility and less than 100% miscibility. The film may comprise a plurality of stabilized quantum dots comprising a first portion of quantum dots that emit light in a first wavelength range upon excitation and a second portion of quantum dots that emit light in a second wavelength range upon excitation. The first portion of the plurality of stabilized quantum dots may be disposed in the first polymer and the second portion of the plurality of stabilized quantum dots may be disposed in the second polymer.

## Description

### Technical Field

The disclosure generally relates to a quantum dot film, and more particularly to methods and structures utilizing a quantum dot film.

### Background

Quantum dots (QDs) represent an area of expanding technological interest as a promising class of emissive materials. These materials may be characterized as semiconductor particles with dimensions on the order of 2 nanometers (nm) to about 100 nm and may often be referred to as nanocrystals. QDs provide size-tunable electronic, optical and chemical properties. QDs may display comparatively strong emission in the visible region of the electromagnetic spectrum while the wavelength of light absorbed and emitted by the QD is a function of the size of the QD.

Various teachings are known in the art that relate to quantum dot films, polymers, or other features related to the disclosure. For example, WO2015022526A1 discloses multi-phase polymer films containing quantum dots (QDs).

"Phase Behavior of Blends of Polycarbonate with Partially Miscible Polymers," (1990) by Kim discloses investigation of phase behavior of blends of bisphenol A polycarbonate (PC) with polystyrene (PS), poly(styrene-co-acrylonitrile) (SAN), poly(acrylonitrile-butadiene-styrene) (ABS), poly(methyl methacrylate) (PMMA), poly(ethylene terephthalate) (PET), and poly(butylene terephthalate) (PBT).

"Energy transfer in aqueous solutions of oppositely charged CdSe/ZnS core/shell quantum dots and in quantum dot-nanogold assemblies," (2004) by Wargnier discloses that the nanoscale assemblies of water-solubilized, oppositely charged CdSe/ZnS core/shell quantum dots and of quantum dots and nanogold particles make it possible to develop FRET-based sensors with a donor quenching efficiency close to 100%.

"Forster Resonance Energy Transfer Investigations Using Quantum-Dot Fluorophores," (2006) by Aaron discloses Fçrster resonance energy transfer (FRET) is very sensitive to nanometer-scale changes in donor-acceptor separation distance and their relative dipole orientations, and discusses some of the basic aspects of FRET applied to QDs as both donors and acceptors, and highlight some of the advantages offered (and limitations encountered) by QDs as energy donors and acceptors compared to conventional dyes.

These teachings in the art have shortcomings in function, cost, and/or other aspects. For example, certain optical constructions or devices making use of quantum dots may be hindered and result in reduced conversion efficiency and color gamut. Thus, there is a need for improved quantum dot films.

### Summary

Compositions and films for light emitting devices are disclosed. According to one example, a film comprising at least one polymer layer comprising a first polymer and a second polymer. The second polymer may exhibit partial miscibility with respect to the first polymer. The partial miscibility of the first polymer relative to the second polymer may be greater than 0% miscibility and less than 100% miscibility. The film may comprise a plurality of stabilized quantum dots comprising a first portion of quantum dots that emit light in a first wavelength range upon excitation and a second portion of quantum dots that emit light in a second wavelength range upon excitation. The first portion of the plurality of stabilized quantum dots may be disposed in the first polymer and the second portion of the plurality of stabilized quantum dots may be disposed in the second polymer such that the first portion of the plurality of stabilized quantum dots are partially dispersed among the second portion of the plurality of stabilized quantum dots. The partial dispersion may be dependent on the partial miscibility of the first polymer relative to the second polymer.

In another aspect, the disclosure relates to a composition comprising a plurality of first stabilized quantum dots disposed in a first polymer. The plurality of first stabilized quantum dots may emit light in a first wavelength range upon excitation. The composition may comprise a plurality of second stabilized quantum dots disposed in a second polymer. The plurality of second stabilized quantum dots may emit light in a second wavelength range upon excitation. The first polymer may be combined with the second polymer such that at least a portion of the plurality of first stabilized quantum dots are caused to be dispersed with at least a portion of the plurality of second stabilized quantum dots. A dispersion of the plurality of first stabilized quantum dots and the plurality of second stabilized quantum dots relative to each other may be dependent on a partial miscibility of the first polymer relative to the second polymer. The partial miscibility of the first polymer relative to the second polymer may be greater than 0% miscibility and less than 100% miscibility. The composition may be capable of being extruded.

In another aspect, the disclosure relates to another composition comprising a plurality of first stabilized quantum dots disposed in a first polymer. The plurality of first stabilized quantum dots may emit light in a first wavelength range upon excitation. The composition may comprise a plurality of second stabilized quantum dots disposed in a second polymer. The plurality of second stabilized quantum dots may emit light in a second wavelength range upon excitation. The first polymer may be combined with the second polymer and a compatibilizer such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a partial miscibility of the first polymer relative to the second polymer and the compatibilizer. The first polymer may be immiscible relative to the second polymer without the compatibilizer. The composition may be capable of being extruded.

The present disclosure also relates to an article comprising the disclosed film and/or composition. The present disclosure also relates to a method of forming disclosed film and/or composition.

### Brief Description of the Drawings

The above-mentioned and other features and advantages of this disclosure, and the manner of attaining them, will become apparent and be better understood by reference to the following description of one aspect of the disclosure in conjunction with the accompanying drawings, wherein:
FIG. 1A is a diagram illustrating example light emission and absorption.
FIG. 1B is a diagram illustrating another example of light emission.
FIG. 2 is a diagram illustrating an example quantum dot layer.
FIG. 3A is a schematic representation of a cross-section of a film according to an aspect of the present disclosure.
FIG. 3B is a three-dimensional representation of a film according to an aspect of the present disclosure.
FIG. 4A is a diagram illustrating an example backlight structure.
FIG. 4B is a diagram illustrating an example optical device.
FIG. 5A is a diagram illustrating an example process for forming a structure.
FIG. 5B is a diagram illustrating another example process for forming a structure.
FIG. 6A is a diagram illustrating another example process for forming a structure.
FIG. 6B is a diagram illustrating another example process for forming a structure.
FIG. 7 is a graph illustrating intensity and wavelength for different films.
FIG. 8A is a graph illustrating a glass transition temperatures of separate polymers.
FIG. 8B is a graph illustrating another glass transition temperature of a miscible polymer blend.
FIG. 8C is a graph illustrating another transition temperature of an immiscible polymer blend.

### Detailed Description

The present disclosure can be understood more readily by reference to the following detailed description of the disclosure and the Examples included therein. In various aspects, the present disclosure pertains to a quantum dot film including at least one extruded polymer layer, the at least one extruded polymer layer including a plurality of stabilized quantum dots. A first portion of the plurality of stabilized quantum dots may be phase separated within the extruded polymer layer from a second portion of the plurality of stabilized quantum dots. The stabilized quantum dots may include one or more of the following: an encapsulation around each of the plurality of stabilized quantum dots, the encapsulation including an organic material or an inorganic material; a plurality of ligands having a length of about 5 nanometers (nm) to about 200 nm; a multi-shell structure; a shell having a thickness of about 1 to about 20 nm; a concentration-gradient quantum dot; a structure having a lattice parameter tuned to reduce lattice stress; a core having an alloy to match a lattice of a shell; and an outer shell thickness and an inner shell thickness balanced to reduce lattice strain.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting.

Various combinations of elements of this disclosure are encompassed by this disclosure, e.g., combinations of elements from dependent claims that depend upon the same independent claim.

Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; and the number or type of aspects described in the specification.

As luminescent nanomaterials, QDs provide size-controlled tunable emission wavelengths and feature almost continuous above-band-edge absorption and a narrow emission spectrum at near-band-edge energies. The optical spectra of QDs depend directly on their size. Thus, their emission color may be continuously tuned from the infrared (IR) to ultraviolet (UV) by altering QD size and/or composition. The range of colors that can be displayed by an LCD device may be referred to as color gamut and may be determined by the combined spectra of the backlight unit and the color filters of the LCD panel. In conventional QD films, randomly distributed, blends of quantum dots at varying sizes, which correspond to different emission wavelengths, may be suspended or dispersed throughout one or more layers of a polymer film. When used in conjunction with a blue LED light source limitations arise. Random distribution of dots may result in some QDs being completely or substantially blocked by other quantum dots in the optical path from the excitation light source (e.g., the blue LED) such that the QDs are not equally exposed to the light source for excitation. Moreover, because of the mixture of varying sizes, green fluorescence from the smaller QDs may be reabsorbed by larger QDs and converted to red fluorescence. This occurrence may result in reduced conversion efficiency of the QDs because the quantum yield (here, for example, photons emitted/photons absorbed) would be less than one. Uncontrolled fluorescence light may vary the light intensity ratio or profiles of blue, red, and green in local areas.

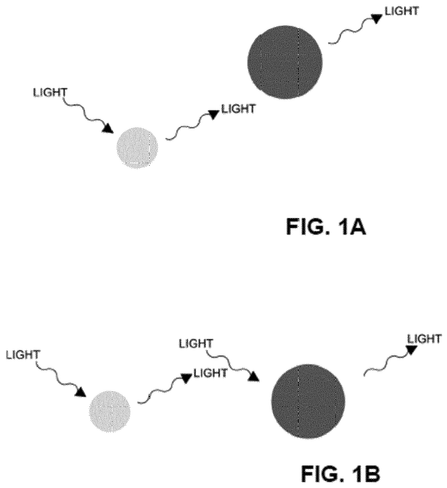

When two different size QDs are mixed in one layer, shorter wavelength emission from smaller QDs can be reabsorbed to larger QDs, as shown in FIG. 1A. This reabsorption of green light to red QD causes energy loss during reconverting process. The present disclosure decreases or prevents green light emitted by smaller QDs from absorbing to larger QDs, thereby increasing quantum efficiency as shown in FIG. 1B.

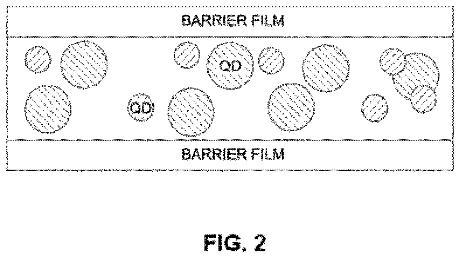

To prevent light reabsorption of shorter wavelength by smaller QDs to larger QDs, a layer structure may be used. In a layer structure, a blue light source is converted to red light through a first red QD layer, then blue and red light transmitted through first layer is converted to green light through a second green QD layer. Red light converted through the first layer may not reabsorb to the smaller green QD thus quantum efficiency can be highly maintained. However the fabrication of multiple QD layers is a costly and complicated process. FIG. 2 shows a simple one layer QD film that may be used instead of complicated multi-layer structure. The one layer structure may lose some energy due to reabsorption by larger QDs of energy emitted from smaller QDs. As described further herein, the present disclosure describes a process for making more efficient one layer QD films (e.g., or to include QDs emitting different wavelengths in a single layer).

In various aspects of the present disclosure, quantum dots of different sizes may be disposed in a single layer. Larger quantum does may disposed in a first polymer and smaller quantum dots may be disposed in a second polymer. The first polymer and the second polymer may be partially miscible or immiscible with respect to each other. The first polymer and the second polymer may be mixed together, resulting in a single layer having phase separated regions in which the larger quantum dots are separated from the smaller quantum dots. These phase separated regions decrease and/or prevent the larger quantum dots from absorbing light emitted from the smaller quantum dots, thereby resulting in a more efficient film.

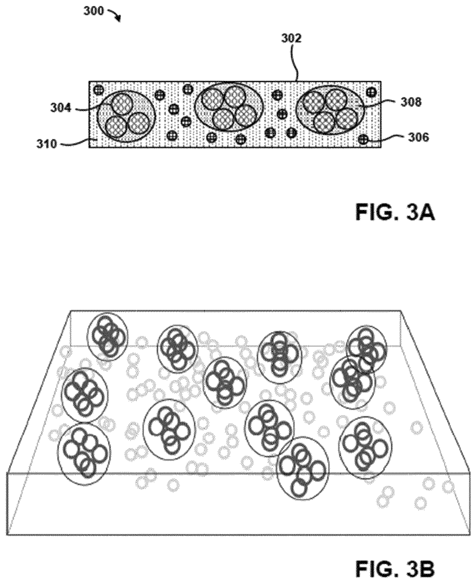

FIG. 3A shows a cross-sectional view of an example film 300. FIG. 3B shows a three dimensional view of the example film 300. The film 300 may comprise a quantum dot layer 302. The quantum dot layer 302 of the film 300 may have a particular thickness. The thickness of quantum dot layers may range from 10 micrometers (micron, µm) to 1000 µm. For example, the quantum dot layer may have a thickness of about 100 µm.

The quantum dot layer 302 may comprise a plurality of stabilized quantum dots. The plurality of stabilized quantum dots may comprise a plurality of first stabilized quantum dots 304. The plurality of stabilized quantum dots may comprise a plurality of second stabilized quantum dots 306. The plurality of first stabilized quantum dots 304 may emit light in a first wavelength range upon excitation. The plurality of first stabilized quantum dots 304 may comprise quantum dots sized from about 3 nanometers (nm) to about 11 nm. The plurality of first stabilized quantum dots 304 may comprise red phosphor with a peak emission wavelength between about 600 nm to about 750 nm. The plurality of second stabilized quantum dots 306 may emit light in a second wavelength range upon excitation. The plurality of second stabilized quantum dots 306 may comprise quantum dots sized from about 1 nm to about 8 nm. The plurality of second stabilized quantum dots 306 may comprise green phosphor with a peak emission wavelength between about 490 nm to about 580 nm.

The plurality of first stabilized quantum dots 304 may comprise a core shell structure, such as a nanocrystal shell structure. The plurality of second stabilized quantum dots 306 may comprise a core-shell structure, such as a nanocrystal shell structure. The plurality of first stabilized quantum dots 304 and/or the plurality of second stabilized quantum dots 306 may comprise CdS, CdSe, CdTe, ZnS, ZnSe, ZnTe, ZnO, HgS, HgSe, HgTe, GaN, GaP, GaAs, GaSb, AlN, AlP, AlAs, AISb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

The plurality of first quantum stabilized dots 304 may be disposed in a first polymer 308 (e.g., or first polymer matrix). The plurality of second stabilized quantum dots 306 disposed in a second polymer 310 (e.g., or second polymer matrix). The first polymer 308 may be combined with the second polymer 310 such that at least a portion of the plurality of first stabilized quantum dots 304 are caused to be dispersed with at least a portion of the plurality of second stabilized quantum dots 306. A dispersion of the plurality of first stabilized quantum dots 304 and the plurality of second stabilized quantum dots 306 relative to each other may be dependent on a miscibility of the first polymer 308 relative to the second polymer 310. The first polymer 308 may be partially miscible or immiscible relative to the second polymer 310. The partial miscibility or the immiscibility of the first polymer 308 relative to the second polymer 310 may cause phase separation between portions of the plurality of first stabilized quantum dots 304 and portions of the plurality of second stabilized quantum dots 306.

The miscibility of the first polymer 308 relative to the second polymer 319 may be greater than 0% and not more than 100%. A solubility parameter may be indicative of the miscibility. Two polymers that have solubility parameters within a threshold similarity (e.g., or threshold range, threshold difference) may be partially miscible. For example, the first polymer 308 may have a first solubility parameter value. The second polymer 310 may have a second solubility parameter value. The first solubility parameter value may be within a threshold similarity (e.g., or threshold range, threshold difference) or the second solubility parameter value. Example solubility parameters are shown in the Table 1, as shown below:

**Table 1**

| **Polymers** | ***δ*/10³ J^{1/2}m^{-3/2}** |
|---|---|
| Polyethylene | 16.4 |
| Polystyrene | 18.5 |
| Polymethylmethacrylate | 19.0 |
| Polypropylene | 17 |
| Poly(vinyl chloride) | 20.0 |
| Polybutadiene | 14.6-17.6 |
| Polychloroprene | 15.2-19.2 |
| Polycrylonitrile | 25.3-31.5 |
| Poly(vinyl acetate) | 18.0-19.1 |
| Polyisobutylene | 14.5-16.5 |
| Poly(vinyl alcohol) | 25.8 |
| Nylon66 | 27.8 |

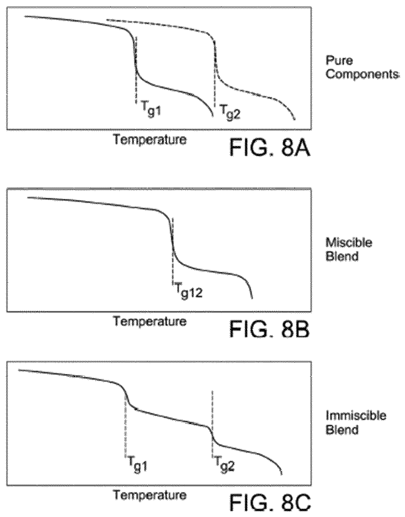

As another example, a glass transition temperature may be indicative of the miscibility. The glass transition temperature may comprise a temperature and/or temperature range at which a polymer changes from a rigid state to a pliable state. The first polymer 308 may have a first glass transition temperature. The second polymer 310 may have a second glass transition temperature. A combination of the first polymer 308 and the second polymer 310 may have a single glass transition temperature, if the first polymer 308 is partially miscible with the second polymer 310. A combination of the first polymer 308 and the second polymer 310 may have multiple glass transition temperatures, if the first polymer 308 is immiscible with the second polymer 310. FIG. 8A illustrates the glass transition temperature of the first polymer 308 and the second polymer 310 when separate. As shown in FIG. 8B, if the first polymer 308 and the second polymer 310 are miscible, then the combination of the first polymer 308 and the second polymer 310 have a single glass transition temperature. As shown in FIG. 8C, if the first polymer 308 and the second polymer 310 are immiscible, then the combination of the first polymer 308 and the second polymer 310 may have multiple glass transition temperature.

The first polymer 308 and/or the second polymer 310 may be combined with a compatibilizer. The first polymer 308 and the second polymer 310 may immiscible without the compatibilizer. The first polymer 308, the second polymer 310, and the compatibilizer may be partially miscible. For example, combining the compatibilizer with the first polymer 308 and the second polymer 310 may cause the first polymer and the second polymer to be partially miscible. Combining the compatibilizer with the first polymer 308 and/or the second polymer 310 may cause a change in a miscibility and/or immiscibility of the first polymer 308 relative to the second polymer 310. The compatibilizer may comprise a copolymer, such as a block copolymer. The copolymer (e.g., block copolymer) may comprise the first polymer 308 (e.g., a unit or subunit of the first polymer 308). The copolymer (e.g., block copolymer) may comprise the second polymer 310 (e.g., a unit or subunit of the second polymer 310). As an illustration, if the first polymer 308 comprises polymethylmethacrylate (PMMA) and the second polymer 310 comprises polycarbonate (PC), then the copolymer may comprise a PMMA-PC block copolymer. As another illustration, if the first polymer 308 comprises Polystyrene (PS) and the second polymer 310 comprises PC, then the copolymer may comprise a PMMA-PC block copolymer. The following are example polymer combinations that may be combined with a compatibilizer: polycarbonate (PC) and polyethylene terephthalate (PET), Polyethylene (PE) and Polystyrene (PS), Polycarbonate (PC) and Polyethylene (PE), Polycarbonate(PC) and Polypropylene(PP), Polypropylene (PP) and Polyvinylchloride (PVC), Polyethylene (PE) and Polyvinylidene fluoride (PVdF), Polymethylmethacrylate (PMMA) and Polystyrene(PS), Polycarbonate (PC) and Polystyrene(PS), Polycarbonate(PC) and Polymethylmethacrylate(PMMA), a combination thereof and/or the like.

The first polymer 308 and/or the second polymer 310 may comprise a commodity resin, an engineering resin, a specialty resin, or a combination thereof. The first polymer 308 and/or the second polymer 310 may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

The following combinations are examples of partially miscible or immiscible combinations of polymers: polycarbonate and polymethylmethacrylate, polystyrene and polybutadiene, polyethylene terephthalate and polyvinylalcohol, polystyrene and polyethylene, polypropylene and polyamide, and/or the like. The following combinations are examples of miscible combinations of polymers which may not be able to achieve phase separation in a single layer: polyphenylene oxide (PPO) and polystyrene (PS), polyethylene terephthalate (PET) and polybutylene terephthalate (PBT), poly(methyl methacrylate) (PMMA) and polyvinylidene fluoride (PVDF), Polypropylene (PP) and ethylene propylene diene monomer (EPDM), polycarbonate (PC) and acrylonitrile butadiene styrene (ABS).

In some aspects, the plurality of stabilized quantum dots 304, 306 are thermally stabilized, air stabilized, moisture stabilized and/or flux stabilized, as described in further detail herein. The inclusion of stabilized quantum dots in the quantum dot film 300 allows the barrier layer(s) (protective layers) found in conventional quantum dot films to be eliminated, resulting in a quantum dot film that has improved optical properties as compared to conventional quantum dot films that include one or more barrier layers. In addition, elimination of the barrier layer(s) allows for formation and use of a thinner quantum dot film. Thinner quantum dot films are more useful in various applications, including display applications as discussed further herein.

The plurality of stabilized quantum dots 304, 306 may be stabilized in any suitable manner. In some aspects, the plurality of stabilized quantum dots 304, 306 are stabilized by providing an encapsulation around each of the plurality of stabilized quantum dots, the encapsulation including an organic material or an inorganic material. The encapsulation protects the stabilized quantum dot from damage in the same manner that a barrier layer(s) would protect the quantum dot layer in a conventional quantum dot film.

In certain aspects each of the plurality of stabilized quantum dots 304, 306 includes a plurality of ligands having a length of about 5 nanometers (nm) to about 200 nm. The plurality of ligands may include any ligand type that will interact (e.g., attach) to the quantum dot. The plurality of ligands protect the quantum dot from damage.

In further aspects each of the plurality of stabilized quantum dots 304, 306 include a shell having a thickness of about 1 to about 20 nm. In other aspects each of the plurality of quantum dots include a multi-shell structure, such as but not limited to a first shell including a first material and at least a second shell including a second material that may be the same or different than the first material. The plurality of stabilized quantum dots in these aspects may have a core that is of the same or a different material than the shell or multi-shell structure material(s).

In yet further aspects each of the plurality of stabilized quantum dots include a concentration-gradient quantum dot. A concentration-gradient quantum dot includes an alloy of at least two semiconductors. The concentration (molar ratio) of the first semiconductor gradually increases from the core of the quantum dot to the outer surface of the quantum dot, and the concentration (molar ratio) of the second semiconductor gradually decreases from the core of the quantum dot to the outer surface of the quantum dot. Exemplary concentration-gradient quantum dots are described in, e.g., U.S. Patent No. 7,981,667, the disclosure of which is incorporated herein by this reference in its entirety.

In one aspect, the concentration-gradient quantum dot includes two semiconductors, a first semiconductor having the formula

CdₓZn₁₋ₓS_{y}Se_{1-y}

and a maximum molar ratio at the core of the stabilized quantum dot that gradually decreases to a minimum molar ratio at the outer surface of the quantum dot and a second semiconductor having the formula

Zn_{z}Se_{1-z}S_{w}Se_{1-w}

and a maximum molar ratio at the outer surface of the stabilized quantum dot that gradually decreases to a minimum molar ratio at the core of the stabilized quantum dot.

In another aspect, the concentration-gradient quantum dot includes two semiconductors, a first semiconductor having the formula

CdZnₓS₁₋ₓ

and a maximum molar ratio at the core of the stabilized quantum dot that gradually decreases to a minimum molar ratio at the outer surface of the quantum dot and a second semiconductor having the formula

ZnCd_{z}S_{1-z}

and a maximum molar ratio at the outer surface of the stabilized quantum dot that gradually decreases to a minimum molar ratio at the core of the stabilized quantum dot.

In an aspect, the stabilized quantum dots may be stabilized based on a core / multi-shell structure. The stabilized quantum dots may be stabilized based on a thickness of one or more of an inner shell or an outer shell of the quantum dot. For example, the thickness of an inner shell and the thickness of an outer shell of the quantum dots may be balanced to provide stability. Lattice strain may be reduced by balancing the thicknesses of the inner and outer shells. The thickness may be chosen to optimize stability. The stabilized quantum dots may be stabilized by tuning lattice parameters of one or more of a core, an inner shell, or an outer shell of the quantum dots. The lattice parameters may be tuned to reduce lattice stress. Exemplary lattice tuning parameters are described in, e.g., U.S. Patent No. 8,343,576, the disclosure of which is incorporated herein by this reference in its entirety.

In an aspect, the stabilized quantum dots may be stabilized based by using a graded composition (e.g., as further described herein). A quantum dot may comprise a core enclosed by a graded shell. For example, a graded alloy shell may be grown on a core (e.g., a small core, a CdSe core) to minimize internal lattice defects at the core-shell interface.

In an aspect, the stabilized quantum dots may be stabilized based on a graded intermediate shell (e.g., or graded inner shell). The graded intermediate shell may be configured to reduce strain caused by lattice mismatch between core and shell. For example, the core may comprise CdSe and an outer shell may comprise ZnS. The graded intermediate shell may comprise Cd ₁₋ₓZnₓSe_{1-y}S_{y}. The graded intermediate shell may transition from a first material of a core to a combination of the first material and a second material of the outer shell. The graded intermediate shell may transition from the combination of the first material / second material to the second material. For example, the quantum dots may transition from CdSe to CdS/ZnSe and from CdS/ZnSe to ZnS).

In an aspect, the stabilized quantum dots may be stabilized based on modification of the core to match a lattice of the shell material. For example, an InP core may be a lattice mismatch for ZnSe_{z}S_{z-1}. The InP core may be modified to match the shell material by adding Zn to form InₓZn_{y}P.

Exemplary quantum dots according to aspects of the disclosure may include, but are not limited to, semiconductor nanocrystals selected from the group consisting of, but not limited to, Group II-VI semiconductor compounds, Group II-V semiconductor compounds, Group III-VI semiconductor compounds, Group III-V semiconductor compounds, Group IV-VI semiconductor compounds, Group II-III-VI compounds, Group II-IV-VI compounds, Group II-IV-V compounds, alloys thereof and combinations thereof. Exemplary Group II elements include Zn, Cd, Hg or a combination thereof. Exemplary Group III elements include Al, Ga, In, Ti or a combination thereof. Exemplary Group IV elements include Si, Ge, Sn, Pb or a combination thereof. Exemplary Group V elements include P, As, Sb, Bi or a combination thereof. Exemplary Group VI elements include O, S, Se, Te or a combination thereof. Exemplary Group II-VI semiconductor compounds include binary compounds, e.g., CdSe, CdTe, ZnS, ZnSe, ZnTe, ZnO, HgS, HgSe and HgTe; ternary compounds, e.g., CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe; and quaternary compounds, e.g., CdZnSeS, CdZnSeTe, CdZnSTe, CdHgSeS, CdHgSeTe, CdHgSTe, HgZnSeS, HgZnSeTe and HgZnSTe. Exemplary Group III-V semiconductor compounds include binary compounds, e.g., GaN, GaP, GaAs, GaSb, AlN, AlP, AlAs, AlSb, InN, InP, InAs and InSb; ternary compounds, e.g., GaNP, GaNAs, GaNSb, GaPAs, GaPSb, AlNP, AlNAs, AlNSb, AlPAs, AlPSb, InNP, InNAs, InN Sb, InPAs, InPSb, GaAlNP, AlGaN, AlGaP, AlGaAs, AlGaSb, InGaN, InGaP, InGaAs, InGaSb, AlInN, AlInP, AlInAs and AlInSb; and quaternary compounds, e.g., GaAlNAs, GaAlNSb, GaAlPAs, GaAlPSb, GaInNP, GaIn, NAs, GaInNSb, GaInPAs, GaInPSb, InAlNP, InAlNAs, InAlNSb, InAlPAs and InAlPSb. Exemplary Group IV-VI semiconductor compounds include binary compounds, e.g., SnS, SnSe, SnTe, PbS, PbSe and PbTe; ternary compounds, e.g., SnSeS, SnSeTe, SnSTe, PbSeS, PbSeTe, PbSTe, SnPbS, SnPbSe and SnPbTe; and quaternary compounds, e.g., SnPbSSe, SnPbSeTe and SnPbSTe. Exemplary Group IV semiconductor compounds include unary compounds, e.g., Si and Ge; and binary compounds, e.g., SiC and SiGe.

Where the plurality of stabilized quantum dots 304, 306 are described herein as having a shell or a multi-shell structure (i.e., a core and at least one shell), the core and the shell or plurality of shells may independently be formed of the semiconductor materials described above.

The semiconductor nanocrystals may have a multilayer structure comprising two or more layers composed of different materials. The multilayer structure of the semiconductor nanocrystals may include at least one alloy interlayer composed of two or more different materials at the interface between the adjacent layers. In one exemplary aspect, the alloy interlayer may be composed of an alloy having a composition gradient. In yet other aspects, the plurality of stabilized quantum dots may comprise quantum dots stabilized by a combination of two or more of these features. In some aspects one or more of the plurality of stabilized quantum dots 304, 306 is a metal nanomaterial or an inorganic nanomaterial. The form of the plurality of stabilized quantum dots 304, 306 may include in certain aspects a nanoparticle, a nanofiber, a nanorod, or a nanowire. The plurality of stabilized quantum dots 304, 306 may have a size of from about 1 nanometer (nm) to about 100 nm in some aspects, or of from about 1 nm to about 50 nm in particular aspects.

In some aspects, the quantum dot layer 302 may comprise a scattering material. The at least one extruded polymer layer may in particular aspects include one or more optional additional additives, including but not limited to a dispersant, a scavenger, a stabilizer or a combination thereof. In particular, a scavenger may be provided to absorb oxygen and/or moisture, which could help to protect the stabilized quantum dot from damage in the presence thereof. Exemplary scavenger materials include, but are not limited to, oxygen scavengers such as hydrazine, Carbo-Hz, sodium sulfite, n,n-diethylhydroxylamine (DEHA), methylethyl ketone oxime (MEKO), erythorbate, hydroquinone, and combinations thereof, and moisture scavengers such as calcium oxide, magnesium oxide, strontium oxide, barium oxide, aluminum oxide, silicone oxide, and combinations thereof. The scavenger in some aspects has a particle size of from about 0.1 micrometer (µm) to about 10 µm.

In some aspects the quantum dot film 300 includes a plurality of layers (e.g., polymer layers, substrate layers, functional layers). The plurality of layers may be extruded layers (e.g., using co-extrusion or multi-layer extrusion). For example, plurality of layers may be disposed below and/or above the quantum dot layer 310. Each of the plurality of layers may comprise a plurality of stabilized quantum dots as described above. For example, each layer may comprise phase separated regions with corresponding portions of the plurality of stabilized quantum dots. One or more of the plurality of layers may include texturing for modifying the optical properties of the quantum dot film 300, as desired. The texturing may be disposed on the bottom side and/or topside of the quantum dot layer 310. The texturing may be disposed on the bottom side and/or topside of any of the plurality of layers.

In some aspects, the quantum dot film 300 does not include a barrier layer such as those found in conventional quantum dot films. As a result, the quantum dot film 300 may be made with fewer processes, and thinner quantum dot films can be made. These improvements reduce the cost of the quantum dot film and enhance the optical properties of the quantum dot film. In particular, in the case of quantum dot films including a plurality of extruded polymer layers, the plurality of extruded polymer layers are seamless (in contrast to conventional quantum dot films including one or more barrier layers), which further enhances the optical properties of the quantum dot film because light emitted by the stabilized quantum dots is not affected as it travels from one extruded polymer layer to the other.

### Properties of Stabilized Quantum Dots

The plurality of stabilized quantum dots included in a quantum dot film according to aspects of the disclosure have improved properties as compared to quantum dots included in conventional quantum dot films. The plurality of stabilized quantum dots are one or more of thermally stabilized, air stabilized, moisture stabilized and flux stabilized.

In some aspects, the plurality of stabilized quantum dots are thermally stabilized such that the quantum dot film exhibits no appreciable degradation of optical properties during an extrusion process. A typical extrusion temperature of an ordinary polymer may be over about 200 degrees Celsius (°C). An extrusion temperature of polypropylene may be at least about 200°C. An extrusion temperature of polycarbonate may be at least about 330°C. An extrusion temperature of polyetherimide may be at least about 400°C. An example extrusion process may be less than about 5 minutes. In some aspects, the plurality of stabilized quantum dots are thermally stabilized such that the quantum dot film exhibits no appreciable degradation of optical properties at a temperature of at least about 200°C. In further aspects, the plurality of stabilized quantum dots are thermally stabilized such that the quantum dot film exhibits no appreciable degradation of optical properties at a temperature of at least about 250°C, or at a temperature of at least about 300°C, or at a temperature of at least about 330°C, or at a temperature of at least about 350 °C, or at a temperature of at least about 380°C, or at a temperature of at least about 400 °C.

As used herein, "appreciable degradation of optical properties" means that, when the stabilized quantum dot is exposed to the stated condition, the emission spectra of the stabilized quantum dot either does not change or does not change to a substantial degree (e.g., the change is less than about 10%). Emission spectra of a quantum dot may be quantified by measuring the width of the Gaussian curve of the emission spectra at half of its maximum value, known as "full width at half maximum," or FWHM. Degradation of a quantum dot under adverse conditions such as those described herein can cause its FWHM to increase and its peak wavelength to shift, resulting in a change in optical properties. Thus, in some aspects an "appreciable degradation of optical properties" may include a change in FWHM of more than about 10% or a shift in peak wavelength of more than about 10%.

In certain aspects the plurality of stabilized quantum dots are air stabilized such that the quantum dot film exhibits no appreciable degradation of optical properties when exposed to air having a relative humidity of 95% and a temperature of 60 °C for 1000 hours. In further aspects the plurality of stabilized quantum dots are moisture stabilized such that the quantum dot film exhibits no appreciable degradation of optical properties when exposed to air having a relative humidity of 95% and a temperature of 60 °C for 1000 hours. In particular aspects the plurality of stabilized quantum dots are flux stabilized such that the quantum dot film exhibits no appreciable degradation of optical properties when exposed to an acceleration flux of 350 milliwatt per square centimeter (mW/cm²) for 100 hours. In specific aspects, the plurality of stabilized quantum dots are flux stabilized and thermal stabilized such that the quantum dot film exhibits no appreciable degradation of optical properties when exposed for 100 hours to an acceleration flux of 350 mW/cm² in air having a temperature of 60 °C.

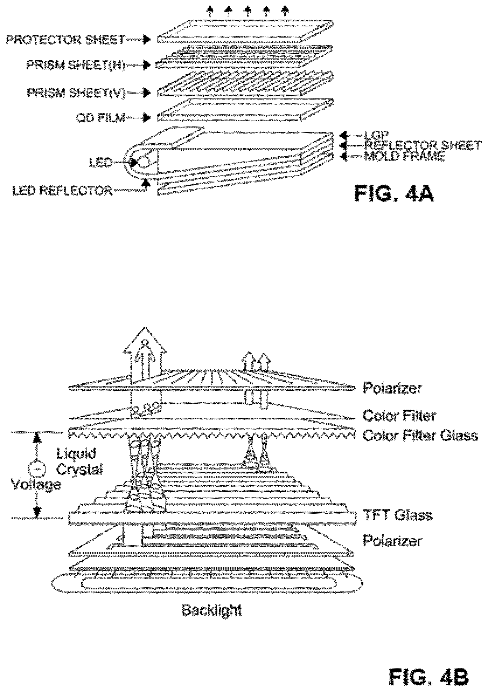

The quantum dot layer 302 may be disposed adjacent to a light source (e.g., as shown in FIG. 4A). The light source may comprise a blue light emitting source. For example, the blue light source may emit light in a range from 440 nm to 460 nm. The blue light source may have a Full Width, Half Max (FWHM) of less than 25 nm. The film may be a part of an optical device comprising an LCD panel having a native color gamut in a range from 35% to 45% NTSC, and one or more QD layers (as described herein) positioned or optically between the blue light source and the LCD panel. The optical construction may achieve a color gamut of at least 50% NTSC in some aspects.

In further examples, the composition of the first polymer and/or the second polymer may also be tailored to provide improved compatibility between the polymer and the surface chemistry of the plurality of first quantum dots and/or the plurality of second stabilized quantum dots. Accordingly, layers of the film may comprise a polymer (e.g., polymer matrix), a plurality of particular quantum dots, and in some aspects one or more compatibilizing additives. These additives may make the polymer more compatible with the QD. In further examples, the first polymer may be selected to be compatible to a ligand encapsulating the plurality of first quantum dots and the second polymer matrix may be selected to be compatible to a ligand encapsulating the plurality of second stabilized quantum dots. In another aspect, the ligand encapsulating the plurality of first quantum dots may be compatible (e.g., or may be selected to be compatible) with the first polymer. The ligand encapsulating the plurality of second stabilized quantum dots may be compatible (e.g., or may be selected to be compatible) with the second polymer.

The quantum dot layers described herein may have any useful amount of quantum dots. In many embodiments the quantum dot layer can have from about 0.001 wt% to about 10 wt% quantum dots or from about 0.05 to about 5 wt. % quantum dots. It is understood that various intervening endpoints in the proposed size ranges may be used. However, other loadings of quantum dots may be used.

### Articles of Manufacture

Aspects of the disclosure also related to an article including the quantum dot film (or films) described herein. In some aspects the article is a display for an electronic device. The electronic device may include but is not limited to a mobile device, a tablet device, a gaming system, a handheld electronic device, a wearable device, a television, a desktop computer, or a laptop computer. The quantum dot film may in particular aspects be used in multi-layer extrusion (MLE), micro lens, prism and diffuser applications. Various combinations of elements of this disclosure are encompassed by this disclosure, e.g., combinations of elements from dependent claims that depend upon the same independent claim.

FIG. 4A shows an example backlight structure in which the present film may be integrated. The backlight structure may be configured to emit electromagnetic radiation as part of an optical structure, such as an LCD panel. The backlight structure may comprise a reflector sheet, a mold frame, an LGP, and an LED reflector. The blacklight structure may comprise a quantum dot layer, a horizontal prism layer, a vertical prism layer, a protector sheet, and/or the like.

FIG. 4B shows an example optical device in which the present film may be integrated. The optical device may comprise the backlight structure of FIG. 4A. For example, the optical device may comprise one or more layers of an LCD panel disposed above the backlight structure. The optical device may comprise a bottom polarizer, a thin film transistor (TFT) glass, a color filter glass layer, a color filter layer, a top polarizer, and/or the like.

### Methods of Making

Aspects of the disclosure further relate to methods of making compositions and/or quantum dot films. In various aspects, a method of making a composition and/or a film may comprise forming a first polymer matrix comprising the plurality of first quantum dots disposed in the first polymer. The method may comprise forming a second polymer matrix comprising the plurality of second stabilized quantum dots disposed in the second polymer.

The method may comprise forming a combination of the first polymer matrix and the second polymer matrix. The combination may be a mixture. The combination (e.g., mixture) may be formed by a mechanical process. The first polymer matrix may be combined with the second polymer matrix such that at least a portion of the plurality of first quantum dots are caused to be dispersed with at least a portion of the plurality of second stabilized quantum dots. A dispersion of the plurality of first quantum dots and the plurality of second stabilized quantum dots relative to each other may be dependent on a miscibility of the first polymer relative to the second polymer. The first polymer may be partially miscible or immiscible relative to the second polymer.

The partial miscibility or the immiscibility of the first polymer relative to the second polymer may cause phase separation between portions of the plurality of first quantum dots and portions of the plurality of second stabilized quantum dots. The combination may comprise a plurality of phase separated regions. The plurality of phase separated regions may comprise first regions comprising portions of the first polymer and portions of the plurality of first quantum dots. The plurality of phase separated regions may comprise second regions comprising portions of the second polymer and portions of the plurality of second stabilized quantum dots. The plurality of phase separate regions may be separated based on the partial miscibility or immiscibility. The separation may occur during a drying (e.g., or curing) process. The combination of the first polymer matrix and the second polymer matrix may be disposed (e.g., coated) as a solution on a substrate. The solution may be dried (e.g., by heating, curing). Phase separation may occur as the solution dries. The separation may occur during or after an extrusion process. A chemical affinity between the first polymer and the plurality of first quantum dots may at least partially cause the phase separation. A chemical affinity between the second polymer and the plurality of second stabilized quantum dots may at least partially cause the phase separation.

Forming the first polymer matrix may comprise mixing (e.g., mechanically and thermally mixing) a first polymer resin of the first polymer with the plurality of first quantum dots. Forming the second polymer matrix may comprise mixing second polymer resin of the second polymer with the plurality of second stabilized quantum dots. Forming the quantum dot layer comprising the combination of the first polymer matrix and the second polymer matrix may comprise mixing the first polymer resin having the plurality of first quantum dots with the second polymer resin having the second plurality of quantum dots.

Forming the first polymer matrix and/or forming the second polymer matrix may comprise combining (e.g., mixing, dissolving) the first polymer and the second polymer in a solvent. The solvent may be configured to dissolve the first polymer and/or the second polymer. The plurality of first quantum dots and/or the plurality of first quantum dots may be dispersed in the solvent, resulting in a solution. The chemical affinities between the first polymer and the plurality of first quantum dots may cause the plurality of first quantum dots to combine with the first polymer (e.g., during a drying process). The chemical affinities between the second polymer and the plurality of second stabilized quantum dots may cause the plurality of second stabilized quantum dots to combine with the second polymer (e.g., during a drying process).

In a conventional approach, the quantum dots may be formed into a layer using a variety of techniques, such as disposing (e.g., coating) the layer. The layer may disposed via a printing process (such as 3-D printing), a lithography process, or a polymerization process, and/or the like. These techniques may be used to form a layer having the plurality of stabilized quantum dots. In certain aspects the combination may be formed by an extrusion process. This is in contrast to conventional quantum dot films that do not include stabilized quantum dots and that cannot be extruded because the quantum dots used in conventional quantum dot films would be damaged or destroyed by the thermal and mechanical stresses that are inherent to the extrusion process. The use of stabilized quantum dots in aspects of the disclosure enable extrusion processes for making the quantum dot films described herein. Extrusion offers a low-cost method for making high performance quantum dot films.

In such an extrusion process the one or any foregoing components described herein (including the stabilized quantum dots) may first be dry blended together, then fed into an extruder from one or multi-feeders, or separately fed into an extruder from one or multi-feeders. The one or any foregoing components may be first dry blended with each other, or dry blended with any combination of foregoing components, then fed into an extruder from one or multi-feeders, or separately fed into an extruder from one or multi-feeders. The components may be fed into the extruder from a throat hopper or any side feeders.

In some aspects one or any foregoing components described herein (including the stabilized quantum dots) may, prior to extrusion, be prepared as a quantum dot formulation, or quantum dot "ink." The quantum dot formulation may include the stabilized quantum dot particles and optional components including but not limited to a scattering material, a dispersant, a binder, a scavenger, a stabilizer and a combination thereof. The quantum dot formulation could be added to polymer and then fed into the extruder as described herein.

The extruders may have a single screw, multiple screws, intermeshing co-rotating or counter rotating screws, non-intermeshing co-rotating or counter rotating screws, reciprocating screws, conical screws, screws with pins, screws with screens, barrels with pins, rolls, rams, helical rotors, co-kneaders, disc-pack processors, various other types of extrusion equipment, or combinations comprising at least one of the foregoing.

The barrel temperature on the extruder during compounding can be set at the temperature where at least a portion of the polymer in the at least one extruded polymer layer has reached a temperature greater than or equal to about the melting temperature, if the polymer is a semi-crystalline organic polymer, or the flow point (e.g., the glass transition temperature) if the polymer is an amorphous polymer.

The mixture including the foregoing mentioned components may be subject to multiple blending and forming steps if desirable. For example, the composition may first be extruded and formed into pellets. The pellets may then be fed into a molding machine where it may be formed into any desirable shape or product. Alternatively, the composition emanating from a single melt blender may be formed into sheets or strands and subjected to post-extrusion processes such as annealing, uniaxial or biaxial orientation.

The temperature of the melt in the present process may in some aspects be maintained as low as possible in order to avoid excessive degradation of the components (e.g., the polymer in the at least one extruded polymer layer). In certain aspects the melt temperature is maintained between about 250°F and about 550°F, or even between about 250°F and about 450°F. In some aspects the melt processed composition exits processing equipment such as an extruder through small exit holes in a die. The resulting strands of molten resin may be cooled by passing the strands through a water bath. The cooled strands can be chopped into small pellets for packaging and further handling.

The method may include forming the layer on a substrate. The substrate may be transparent, opaque, or any one or more colors. The solid plastic form can include any one or more suitable plastics (e.g., as a homogeneous mixture of plastics).

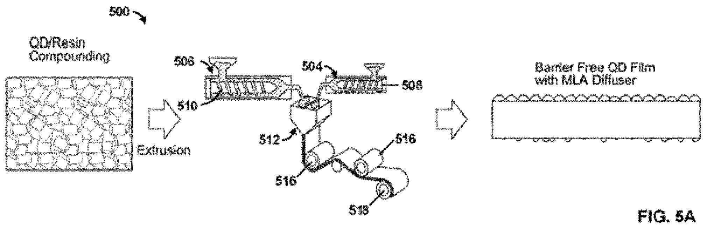

FIG. 5A illustrates an example extrusion process 500. An extruder 502 may comprise one or more feeders, such as a first feeder 504 and a second feeder 506. One or more polymer resins may be fed into the one or more feeders. For example, the plurality of stabilized quantum dots may be mixed with polymer pellets in the one or more feeders. As another example, the polymer pellets may comprise the plurality of stabilized quantum dots. The first feeder 504 may receive a plurality of first stabilized quantum dots. The first stabilized quantum dots may comprise the properties described herein. The first feeder 504 may also receive a first polymer material, such as pellets comprising the first polymer material. The first feeder 504 may receive a plurality of first pellets comprising the first stabilized quantum dots and a first polymer material. The first feeder 504 may also receive a plurality of second pellets comprising second stabilized quantum dots and a second polymer material. The second stabilized quantum dots may comprise the properties described herein. The plurality of first pellets and the plurality of second pellets may be separately prepared before extrusion. The first feeder 504 may form a layer comprising both the first stabilized quantum dots and the second stabilized quantum dots. The second feeder 506 may also receive additional materials, such as optical enhancement materials (e.g., diffuser particles, etc).

The extruder 502 may comprise one or more extrusion chambers, such a first extrusion chamber 508 and a second extrusion chamber 510. The one or more extrusion chambers may comprise a mixing members, such as a screw, pin, kneeder, and/or the like. The one or more extrusion chambers may be configured to cause melting of material received from the one or more feeders. The extruder 502 may comprise a co-extrusion die 512 configured to receive material from the one or more extrusion chambers and form the material into a film. The co-extrusion die 512 may form the material into a co-extruded film 514. The extruder 502 may comprise also comprise other components to manage the film, such as rollers 516 and winder 518.

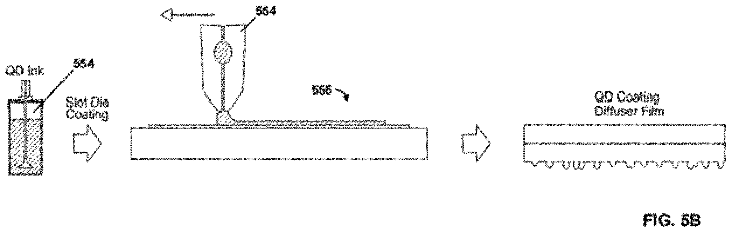

FIG. 5B illustrates an example process 550 for forming a structure. The process 550 may comprise forming a quantum dot formulation 552, or quantum dot "ink." The quantum dot formulation 552 may comprise the stabilized quantum dot particles and optional components including but not limited to a scattering material, a dispersant, a binder, a scavenger, a stabilizer and a combination thereof. The quantum dot formulation 552 may be provided to a coating die 554. The coating die may comprise a slot 556 for coating the quantum dot formulation 552 onto structure, such as coating a layer of a film on top of another layer. The quantum dot formulation 552 may be coated as a layer on top of another layer, such as a substrate, or a functional layer (e.g., diffuser layer). As an example, the resulting structure may comprise a quantum dot layer with stabilized quantum dots disposed in phase separated regions of different polymers. For example, a plurality of first stabilized quantum dots may disposed in regions of a first polymer that may be partially miscible or immiscible with regions of a second polymer. The second polymer may comprise a plurality of second stabilized quantum dots. Phase separation may occur spontaneously during solvent drying process. The first polymer and second polymer may be selected with partial miscibility and immiscibility. The plurality of first stabilized quantum dots and plurality of second stabilized quantum dots may have different affinity with the first polymer and the second polymer relatively. Due to these different chemical affinities, forming a coated layer comprising the first polymer, the second polymer, the plurality of first stabilized quantum dots and the plurality of second stabilized quantum dots will cause phase separation during the drying process.

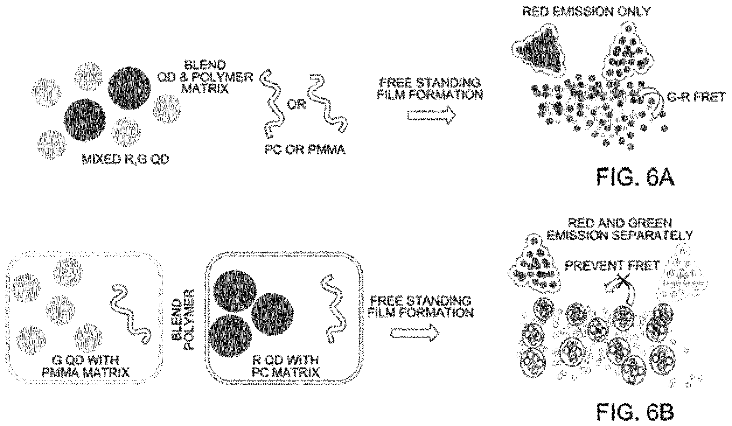

FIG. 6A is a diagram illustrating a process for forming a film. As shown on the left, red and green quantum dots may be mixed with a polymer matrix, such as PC or PMMA. The resulting film is shown on the right. Due to fluorescence resonance energy transfer (FRET), green light is absorbed by the red quantum dots, resulting in only emission of red light.

FIG. 6B is a diagram illustrating another process for forming a film based on the present disclosure. As shown on the left, green quantum dots are mixed with a PMMA based polymer matrix. Red quantum dots are mixed with a PC based polymer matrix. Both mixtures are combined and formed into a film. The resulting film emits green light and red light separately. The phase separation between the two different polymers reduces or prevents the absorption of green light related to FRET.

### Examples

By way of illustration and as a non-limiting example, a quantum dot film was formed according to the following specifications. The example quantum dot film was formed with a thickness of about 100 µm. The emission wavelength of the quantum dots was 525 nm (green) and 629 nm (red). The polymers for the quantum dot film included PMMA (e.g., for green quantum dots) and PC (e.g., for red quantum dots). To make a 15.4 x 9.85 cm² film, 51 mg of red QDs were mixed with 0.2 mL of Polycarbonate (PC) dissolved in chloroform. The concentration of PC solution was 10%. 91 mg of green QDs were mixed with 5 mL of Polymethylmethacrylate (PMMA) dissolved in chloroform. The concentration of PMMA solution was 10%. Testing of the example quantum dot film indicated that the ratio of materials used showed exact white color (0.33, 0.33).

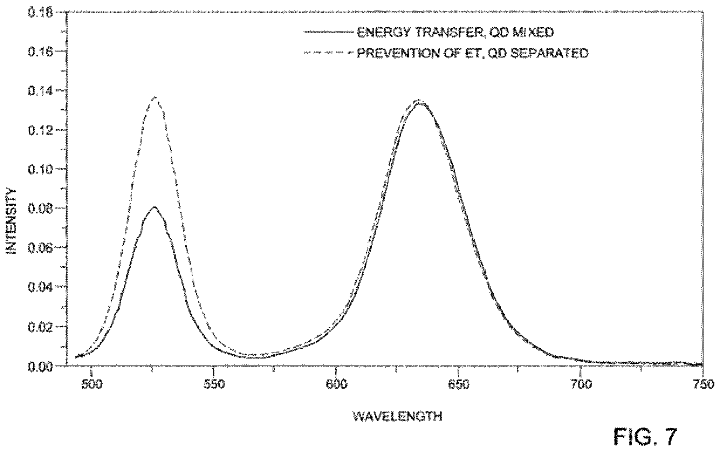

FIG. 7 shows that the example quantum dot film shows high green light intensity compared with mixed QD film. This result indicates that the reabsorption of green light from green QDs to red QDs is effectively prevented. Additionally, this formulation can be applied to the same QD film making process without any process modification. FIG. 7 illustrates intensity and wavelength for the example quantum dot film and control film illustrated in FIG. 6A and FIG. 6B. Two QD films were prepared following the composition as shown in Table 1.

**Table 1. Composition of QD films**

| | **Test (QD separated)** | **Control (QD mixed)** |
|---|---|---|
| Green QDs amount | The same | The same |
| Red QDs amount | The same | The same |
| Matrix | PMMA for Green QDs, PC for Red QDs | PC or PMMA |
| Solvent | Chloroform | Chloroform |

In the control system, both green and red QDs were mixed together in the same polymer matrix and positioned randomly. In the test film (e.g., the example quantum dot film described above), green and red QDs were separately mixed with relative polymer resin which is partially miscible. Subsequently, the polymer resin comprising green QD were mixed with the polymer resins (e.g., PMMA and PC) comprising red QDs. Due to the limited miscibility between two different matrix polymers, green QDs and red QDs phase separated spontaneously. This phase separation between green QDs and red QDs reduced the energy transfer and loss as compared to the control film.

As another example, a stabilized quantum dot film was made according to the present disclosure. The example quantum dot film had a thickness of about 300 µm. The example quantum dot film comprised stabilized quantum dots. The stabilized quantum dots were stabilized based on applying a passivation layer to Cd based quantum dots. The passivation layer comprised SiO₂ and Al₂O₃. The emission wavelength of a plurality of first quantum dots disposed in the example QD film was about 525 nm (e.g., green). The emission wavelength of a plurality of second quantum dots disposed in the example QD film was about 629 nm (e.g., red). The polymers used in the example QD film included PC (e.g., for the plurality of first stabilized quantum dots, or green quantum dots) and PMMA (e.g., for the plurality of red quantum dots). In order to make 1 m² film, 257 g of PC pellets containing 0.1 g of green QDs and 43 g of PMMA pellets containing 0.044 g of red QDs were melt extruded. Testing of the example quantum dot film indicated that the ratio of materials used showed exact white color (0.33, 0.33). The example quantum dot film was compared to a control film comprising red and green quantum dots comprising the same materials as the example stabilized quantum dot film. The control film, however, only included PC polymer as a matrix (e.g., instead of PC and PMMA as used in the example film). The control film included 300 g of PC pellets containing 0.1 g of green QD and 0.044 g of red QD. The control film was melt extruded. Due to the limited miscibility between the two different matrix polymers, green QDs and red QDs phase separated spontaneously in the example stabilized QD film. This phase separation between green QDs and red QDs reduced the energy transfer and loss as compared to the control film.

The present disclosure relates to at least the following aspects.
Aspect 1. A film comprising: at least one polymer layer comprising a first polymer and a second polymer, wherein the second polymer exhibits partial miscibility with respect to the first polymer, and wherein the partial miscibility of the first polymer relative to the second polymer is greater than 0% miscibility and less than 100% miscibility; and a plurality of stabilized quantum dots comprising a first portion of quantum dots that emit light in a first wavelength range upon excitation and a second portion of quantum dots that emit light in a second wavelength range upon excitation, wherein the first portion of the plurality of stabilized quantum dots is disposed in the first polymer and the second portion of the plurality of stabilized quantum dots is disposed in the second polymer such that the first portion of the plurality of stabilized quantum dots are partially dispersed among the second portion of the plurality of stabilized quantum dots, and wherein the partial dispersion is dependent on the partial miscibility of the first polymer relative to the second polymer.
Aspect 2. The film of aspect 1, wherein the film does not include a barrier layer.
Aspect 3. The film of any one of aspects 1-2, wherein the first polymer is phase separated from the second polymer.
Aspect 4. The film of any one of aspects 1-3, wherein the first portion of the plurality of stabilized quantum dots is partially dispersed from the second portion of the plurality of stabilized quantum dots based on a partial miscibility of the first polymer relative to the second polymer and a compatibilizer, wherein the first polymer is immiscible relative to the second polymer without the compatibilizer.
Aspect 5. The film of aspect 4, wherein the compatibilizer comprises a block copolymer comprising the first polymer and the second polymer.
Aspect 6. The film of any one of aspects 1-5, wherein each of the plurality of stabilized quantum dots comprise one or more of the following: an encapsulation around each of the plurality of stabilized quantum dots, the encapsulation comprising an organic material or an inorganic material; a plurality of ligands having a length of about 5 nanometers (nm) to about 200 nm; a multi-shell structure; a shell having a thickness of about 1 to about 20 nm; a concentration-gradient quantum dot; a core and a shell enclosing the core, the core and the shell comprising an alloy; a structure having a lattice parameter tuned to reduce lattice stress; a core having an alloy to match a lattice of a shell; and an outer shell thickness and an inner shell thickness balanced to reduce lattice strain.
Aspect 7. The film of any one of aspects 1-6, wherein one or more of the plurality of stabilized quantum dots comprises a metal nanomaterial or an inorganic nanomaterial.
Aspect 8. The film of any one of aspects 1-7, wherein one or more of the plurality of stabilized quantum dots comprises a nanoparticle, a nanofiber, a nanorod, or a nanowire.
Aspect 9. The film of any one of aspects 1-8, wherein one or more of the plurality of stabilized quantum dots has a size of from about 1 nanometer (nm) to about 100 nm.
Aspect 10. The film of any one of aspects 1-9, wherein the plurality of stabilized quantum dots are thermally stabilized such that the film exhibits no appreciable degradation of optical properties at a temperature of at least about 200 degrees Celsius (°C) for a period of about 5 minutes.
Aspect 11. The film of any one of aspects 1-10, wherein the plurality of stabilized quantum dots are air stabilized such that the film exhibits no appreciable degradation of optical properties when exposed to air having a relative humidity of 95% and a temperature of 60 °C for 1000 hours.
Aspect 12. The film of any one of aspects 1-11, wherein the plurality of stabilized quantum dots are moisture stabilized such that the film exhibits no appreciable degradation of optical properties when exposed to air having a relative humidity of 95% and a temperature of 60 °C for 1000 hours.
Aspect 13. The film of any one of aspects 1-12, wherein the plurality of stabilized quantum dots are flux stabilized such that the film exhibits no appreciable degradation of optical properties when exposed to an acceleration flux of 350 milliwatt per square centimeter (mW/cm2) for 100 hours.
Aspect 14. The film of any one of aspects 1-13, wherein the plurality of stabilized quantum dots are flux stabilized and thermal stabilized such that the film exhibits no appreciable degradation of optical properties when exposed for 100 hours to an acceleration flux of 350 mW/cm2 in air having a temperature of 60 °C.
Aspect 15. The film of any one of aspects 1-14, wherein the at least one polymer layer comprises a polymer selected from the group consisting of polycarbonate (PC), polyethylene terephthalate (PET), polymethyl methacrylate (PMMA), polyaryletherketones (PAEK), polybutylene terephthalate (PBT), cyclic olefin copolymer (COC), polyethylene naphthalate (PEN), poly(ether sulfone) PES, polyamide (PA), polyphthalamide (PPA), polyimides, polyolefins, polystyrene, and a combination thereof.
Aspect 16. The film of any one of aspects 1-15, wherein the at least one polymer layer further comprises a scattering material.
Aspect 17. The film of aspect 16, wherein the scattering material comprises titanium dioxide (TiO2), silicon dioxide (SiO2), aluminum oxide (Al2O3), zinc oxide (ZnO), zinc peroxide (ZnO2), zirconium dioxide (ZrO2), or a combination thereof.
Aspect 18. The film of any one of claims 1-17, wherein the at least one polymer layer further comprises one or more optional additional additives, the one or more optional additional additives comprising a dispersant, a binder, a scavenger, a stabilizer or a combination thereof.
Aspect 19. The film of any one of aspects 1-18, wherein the film comprises a plurality of extruded polymer layers and the plurality of extruded polymer layers are extruded in a co-extrusion process or a multi-layer extrusion (MLE) process.
Aspect 20. The film of any one of aspects 1-19, wherein the first portion of the plurality of stabilized quantum dots emits light having a first wavelength, and wherein the second portion of the plurality of stabilized quantum dots emits light having a second wavelength, and wherein the first wavelength is different than the second wavelength.
Aspect 21. The film of aspects 20, wherein the first wavelength corresponds to light having a red color and the second wavelength corresponds to light having a green color.
Aspect 22. The film of any one of aspects 1-21, wherein the at least one polymer layer is textured.
Aspect 23. The film of any one of aspects 1-22, wherein the first portion of the plurality of stabilized quantum dots are disposed only in the first polymer and the second portion of the plurality of stabilized quantum dots are disposed only in the second polymer.
Aspect 24. An article comprising the film of any one of aspects 1-23, wherein the article comprises a display for an electronic device, wherein the electronic device is a mobile device, a tablet device, a gaming system, a handheld electronic device, a wearable device, a television, a desktop computer, or a laptop computer.
Aspect 25. A composition comprising: a plurality of first stabilized quantum dots disposed in a first polymer, wherein the plurality of first stabilized quantum dots emit light in a first wavelength range upon excitation; and a plurality of second stabilized quantum dots disposed in a second polymer, wherein the plurality of second stabilized quantum dots emit light in a second wavelength range upon excitation, wherein the first polymer is combined with the second polymer such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a partial miscibility of the first polymer relative to the second polymer, wherein the partial miscibility of the first polymer relative to the second polymer is greater than 0% miscibility and less than 100% miscibility, and wherein the composition is capable of being extruded or coated.
Aspect 26. The composition of aspect 25, wherein the composition is disposed in a film.
Aspect 27. The composition of aspect 26, wherein the film comprises a plurality of extruded polymer layers and the plurality of extruded polymer layers are extruded in a co-extrusion process or a multi-layer extrusion (MLE) process.
Aspect 28. The composition of any one of aspects 26-27, wherein the film is textured.
Aspect 29. The composition of any one of aspects 26-28, wherein the film does not include a barrier layer.
Aspect 30. The composition of any one of aspects 25-29, wherein the partial miscibility of the first polymer relative to the second polymer causes phase separation between portions of the plurality of first stabilized quantum dots and portions of the plurality of second stabilized quantum dots.
Aspect 31. The composition of any one of aspects 25-30, wherein the plurality of first stabilized quantum dots and the plurality of second stabilized quantum dots are disposed in a quantum dot layer adjacent to a light source, and wherein the light source comprises a blue light emitting source.
Aspect 32. The composition of any one of aspects 25-31, wherein the plurality of first stabilized quantum dots comprise quantum dots sized from about 3 nanometers (nm) to about 11 nm.
Aspect 33. The composition of any one of aspects 25-32, wherein the plurality of second stabilized quantum dots comprise quantum dots sized from about 1 nm to about 8 nm.
Aspect 34. The composition of any one of aspects 25-33, wherein one or both of the plurality of first stabilized quantum dots and the plurality of second stabilized quantum dots are disposed in a layer by way of an extrusion process, a coating process, a printing process, a lithography process, a polymerization process, or a combination thereof.
Aspect 35. The composition of any one of aspects 25-34, wherein one or both of the plurality of first stabilized quantum dots and the plurality of second stabilized quantum dots are disposed in a layer by way of a coating process, a printing process, a lithography process, or a polymerization process.
Aspect 36. The composition of any one of aspects 25-36, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.
Aspect 37. The composition of any one of aspects 25-36, wherein one or both of the plurality of first stabilized quantum dots and the plurality of second stabilized quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AISb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.
Aspect 38. The composition of any one of aspects 25-37, wherein one or more of the plurality of first stabilized quantum dots or the plurality of second stabilized quantum dots comprise one or more of the following: an encapsulation around each of one or more of the plurality of first stabilized quantum dots or the plurality of second stabilized quantum dots comprise, the encapsulation comprising an organic material or an inorganic material; a plurality of ligands having a length of about 5 nanometers (nm) to about 200 nm; a multi-shell structure; a shell having a thickness of about 1 to about 20 nm; a concentration-gradient quantum dot; a core and a shell enclosing the core, the core and the shell comprising an alloy; a structure having a lattice parameter tuned to reduce lattice stress; a core having an alloy to match a lattice of a shell; and an outer shell thickness and an inner shell thickness balanced to reduce lattice strain.
Aspect 39. The composition of any one of aspects 25-38, wherein one or more of the plurality of first stabilized quantum dots or the plurality of second stabilized quantum dots comprise a metal nanomaterial or an inorganic nanomaterial.
Aspect 40. The composition of any one of aspects 25-39, wherein one or more of the plurality of first stabilized quantum dots or the plurality of second stabilized quantum dots comprise a nanoparticle, a nanofiber, a nanorod, or a nanowire.
Aspect 41. The composition of any one of aspects 25-40, wherein one or more of the plurality of first stabilized quantum dots or the plurality of second stabilized quantum dots comprise has a size of from about 1 nanometer (nm) to about 100 nm.
Aspect 42. The composition of any one of aspects 25-41, wherein one or more of the plurality of first stabilized quantum dots or the plurality of second stabilized quantum dots are thermally stabilized such that the composition exhibits no appreciable degradation of optical properties at a temperature of at least about 200 °C for a period of about 5 minutes.
Aspect 43. The composition of any one of aspects 25-42, wherein the one or more of the plurality of first stabilized quantum dots or the plurality of second stabilized quantum dots are air stabilized such that the composition exhibits no appreciable degradation of optical properties when exposed to air having a relative humidity of 95% and a temperature of 60°C for 1000 hours.
Aspect 44. The composition of any one of aspects 25-43, wherein one or more of the plurality of first stabilized quantum dots or the plurality of second stabilized quantum dots are moisture stabilized such that the composition exhibits no appreciable degradation of optical properties when exposed to air having a relative humidity of 95% and a temperature of 60 °C for 1000 hours.
Aspect 45. The composition of any one of aspects 25-44, wherein one or more of the plurality of first stabilized quantum dots or the plurality of second stabilized quantum dots are flux stabilized such that the composition exhibits no appreciable degradation of optical properties when exposed to an acceleration flux of 350 milliwatt per square centimeter (mW/cm2) for 100 hours.
Aspect 46. The composition of any one of aspects 25-45, wherein one or more of the plurality of first stabilized quantum dots or the plurality of second stabilized quantum dots are flux stabilized and thermal stabilized such that the composition exhibits no appreciable degradation of optical properties when exposed for 100 hours to an acceleration flux of 350 mW/cm2 in air having a temperature of 60 °C.
Aspect 47. The composition of any one of aspects 25-46, wherein one or more of the first polymer and the second polymer comprises a polymer selected from the group consisting of polycarbonate (PC), polyethylene terephthalate (PET), polymethyl methacrylate (PMMA), polyaryletherketones (PAEK), polybutylene terephthalate (PBT), cyclic olefin copolymer (COC), polyethylene naphthalate (PEN), poly(ether sulfone) PES, polyamide (PA), polyphthalamide (PPA), polyimides, polyolefins, polystyrene, and a combination thereof.
Aspect 48. The composition of any one of aspects 25-47, further comprising a scattering material disposed in the composition.
Aspect 49. The composition of aspect 48, wherein the scattering material comprises titanium dioxide (TiO2), silicon dioxide (SiO2), aluminum oxide (Al2O3), zinc oxide (ZnO), zinc peroxide (ZnO2), zirconium dioxide (ZrO2), or a combination thereof.
Aspect 50. The composition of aspect 49, further comprising one or more optional additional additives disposed in the composition, the one or more optional additional additives comprising a dispersant, a binder, a scavenger, a stabilizer or a combination thereof.
Aspect 51. An article comprising the composition of any one of aspects 25-50, wherein the article comprises a display for an electronic device, wherein the electronic device is a mobile device, a tablet device, a gaming system, a handheld electronic device, a wearable device, a television, a desktop computer, or a laptop computer.
Aspect 52. A composition comprising: a plurality of first stabilized quantum dots disposed in a first polymer, wherein the plurality of first stabilized quantum dots emit light in a first wavelength range upon excitation; and a plurality of second stabilized quantum dots disposed in a second polymer, wherein the plurality of second stabilized quantum dots emit light in a second wavelength range upon excitation, wherein the first polymer is combined with the second polymer and a compatibilizer such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a partial miscibility of the first polymer relative to the second polymer and the compatibilizer, wherein the first polymer is immiscible relative to the second polymer without the compatibilizer, and wherein the composition is capable of being extruded or coated.
Aspect 53. The composition of aspect 52, wherein the composition is disposed in a film.
Aspect 54. The composition of aspect 53, wherein the film comprises a plurality of extruded polymer layers and the plurality of extruded polymer layers are extruded in a co-extrusion process or a multi-layer extrusion (MLE) process.
Aspect 55. The composition of any one of aspects 53-54, wherein the film is textured.
Aspect 56. The composition of any one of aspects 53-55, wherein the film does not include a barrier layer.
Aspect 57. The composition of any one of aspects 52-56, wherein the partial miscibility of the first polymer relative to the second polymer and the compatibilizer causes phase separation between portions of the plurality of first stabilized quantum dots and portions of the plurality of second stabilized quantum dots.
Aspect 58. The composition of any one of aspects 52-57, wherein the plurality of first stabilized quantum dots and the plurality of second stabilized quantum dots are disposed in a quantum dot layer adjacent to a light source, and wherein the light source comprises a blue light emitting source.
Aspect 59. The composition of any one of aspects 52-58, wherein the plurality of first stabilized quantum dots comprise quantum dots sized from about 3 nanometers (nm) to about 11 nm.
Aspect 60. The composition of any one of aspects 52-59, wherein the plurality of second stabilized quantum dots comprise quantum dots sized from about 1 nm to about 8 nm.
Aspect 61. The composition of any one of aspects 52-60, wherein one or both of the plurality of first stabilized quantum dots and the plurality of second stabilized quantum dots are disposed in a layer by way of an extrusion process, a coating process, a printing process, a lithography process, a polymerization process, or a combination thereof.
Aspect 62. The composition of aspect 61, wherein one or both of the plurality of first stabilized quantum dots and the plurality of second stabilized quantum dots are disposed in a layer by way of a coating process, a printing process, a lithography process, or a polymerization process.
Aspect 63. The composition of any one of aspects 52-62, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.
Aspect 64. The composition of any one of aspects 52-63, wherein one or both of the plurality of first stabilized quantum dots and the plurality of second stabilized quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AISb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.
Aspect 65. The composition of any one of aspects 52-64, wherein the compatibilizer comprises a block copolymer comprising the first polymer and the second polymer.
Aspect 66. The composition of any one of aspects 52-65, wherein one or more of the plurality of first stabilized quantum dots or the plurality of second stabilized quantum dots comprise one or more of the following: an encapsulation around each of one or more of the plurality of first stabilized quantum dots or the plurality of second stabilized quantum dots, the encapsulation comprising an organic material or an inorganic material; a plurality of ligands having a length of about 5 nanometers (nm) to about 200 nm; a multi-shell structure; a shell having a thickness of about 1 to about 20 nm; a concentration-gradient quantum dot; a core and a shell enclosing the core, the core and the shell comprising an alloy; a structure having a lattice parameter tuned to reduce lattice stress; a core having an alloy to match a lattice of a shell; and an outer shell thickness and an inner shell thickness balanced to reduce lattice strain.
Aspect 67. The composition of aspect 66, wherein one or more of the plurality of first stabilized quantum dots or the plurality of second stabilized quantum dots is a metal nanomaterial or an inorganic nanomaterial.
Aspect 68. The composition of any one of aspects 52-67, wherein one or more of the plurality of first stabilized quantum dots or the plurality of second stabilized quantum dots is a nanoparticle, a nanofiber, a nanorod, or a nanowire.
Aspect 69. The composition of any one of aspects 52-69, wherein one or more of the plurality of first stabilized quantum dots or the plurality of second stabilized quantum dots has a size of from about 1 nanometer (nm) to about 100 nm.
Aspect 70. The composition of any one of aspects 52-69, wherein one or more of the plurality of first stabilized quantum dots or the plurality of second stabilized quantum dots are thermally stabilized such that the composition exhibits no appreciable degradation of optical properties at a temperature of at least about 200°C for a period of about 5 minutes.
Aspect 71. The composition of any one of aspects 52-70, wherein one or more of the plurality of first stabilized quantum dots or the plurality of second stabilized quantum dots are air stabilized such that the composition exhibits no appreciable degradation of optical properties when exposed to air having a relative humidity of 95% and a temperature of 60 °C for 1000 hours.
Aspect 72. The composition of any one of aspects 52-71, wherein one or more of the plurality of first stabilized quantum dots or the plurality of second stabilized quantum dots are moisture stabilized such that the composition exhibits no appreciable degradation of optical properties when exposed to air having a relative humidity of 95% and a temperature of 60 °C for 1000 hours.
Aspect 73. The composition of any one of aspects 52-72, wherein the one or more of the plurality of first stabilized quantum dots or the plurality of second stabilized quantum dots are flux stabilized such that the composition exhibits no appreciable degradation of optical properties when exposed to an acceleration flux of 350 milliwatt per square centimeter (mW/cm2) for 100 hours.
Aspect 74. The composition of any one of aspects 52-73, wherein one or more of the plurality of first stabilized quantum dots or the plurality of second stabilized quantum dots are flux stabilized and thermal stabilized such that the composition exhibits no appreciable degradation of optical properties when exposed for 100 hours to an acceleration flux of 350 mW/cm2 in air having a temperature of 60 °C.
Aspect 75. The composition of any one of aspects 52-74, wherein one or more of the first polymer or the second polymer comprises a polymer selected from the group consisting of polycarbonate (PC), polyethylene terephthalate (PET), polymethyl methacrylate (PMMA), polyaryletherketones (PAEK), polybutylene terephthalate (PBT), cyclic olefin copolymer (COC), polyethylene naphthalate (PEN), poly(ether sulfone) PES, polyamide (PA), polyphthalamide (PPA), polyimides, polyolefins, polystyrene, and a combination thereof.
Aspect 76. The composition of any one of aspects 52-75, further comprises a scattering material embedded in the composition.
Aspect 77. The composition of any one of aspects 52-76, wherein the scattering material comprises titanium dioxide (TiO2), silicon dioxide (SiO2), aluminum oxide (Al2O3), zinc oxide (ZnO), zinc peroxide (ZnO2), zirconium dioxide (ZrO2), or a combination thereof.
Aspect 78. The composition of any one of aspects 52-77, further comprising one or more optional additional additives, the one or more optional additional additives comprising a dispersant, a binder, a scavenger, a stabilizer or a combination thereof.
Aspect 79. An article comprising the composition of any one of claims 52-78, wherein the article comprises a display for an electronic device, wherein the electronic device is a mobile device, a tablet device, a gaming system, a handheld electronic device, a wearable device, a television, a desktop computer, or a laptop computer.
Aspect 80. A method comprising: forming a first polymer matrix comprising a plurality of first stabilized quantum dots disposed in a first polymer, wherein the plurality of first quantum dots emit light in a first wavelength range upon excitation; forming a second polymer matrix comprising a plurality of second stabilized quantum dots disposed in a second polymer, wherein the second polymer is partially miscible with the first polymer, wherein the plurality of second stabilized quantum dots emit light in a second wavelength range upon excitation; forming a combination of the first polymer matrix and the second polymer matrix, wherein the first polymer matrix is combined with the second polymer matrix such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a miscibility of the first polymer relative to the second polymer, wherein the miscibility of the first polymer relative to the second polymer is greater than 0% and not more than 100%; and forming a quantum dot layer comprising the combination of the first polymer matrix and the second polymer matrix.
Aspect 81. The method of aspect 80, wherein the partial miscibility of the first polymer relative to the second polymer causes phase separation between portions of the plurality of first stabilized quantum dots and portions of the plurality of second stabilized quantum dots.
Aspect 82. The method of any one of aspects 80-81, wherein forming the first polymer matrix comprises mixing first polymer resin of the first polymer with the plurality of first stabilized quantum dots, and wherein forming the second polymer matrix comprises mixing second polymer resin of the second polymer with the plurality of second stabilized quantum dots.
Aspect 83. The method of aspect 82, wherein forming the quantum dot layer comprising the combination of the first polymer matrix and the second polymer matrix comprises mixing the first polymer resin having the plurality of first stabilized quantum dots with the second polymer resin having the second plurality of quantum dots.
Aspect 84. The method of any one of aspects 80-83, wherein forming the quantum dot layer comprising the combination of the first polymer matrix and the second polymer matrix comprises forming the quantum dot layer adjacent to a light source, and wherein the light source comprises a blue light emitting source.
Aspect 85. The method of any one of aspects 80-84, wherein the plurality of first stabilized quantum dots comprise quantum dots sized from about 3 nanometers (nm) to about 11 nm.
Aspect 86. The method of any one of aspects 80-85, wherein the plurality of first stabilized quantum dots comprise red phosphor with a peak emission wavelength between about 600 nm to about 750 nm.
Aspect 87. The method of any one of aspects 80-86, wherein the plurality of second stabilized quantum dots comprise quantum dots sized from about 1 nm to about 8 nm.
Aspect 88. The method of any one of aspects 80-87, wherein the plurality of second stabilized quantum dots comprise green phosphor with a peak emission wavelength between about 490 nm to about 580 nm.
Aspect 89. The method of any one of aspects 80-88, wherein one or both of the plurality of first stabilized quantum dots and the plurality of second stabilized quantum dots are disposed in the quantum dot layer by way of a coating process, a printing process, a lithography process, or a polymerization process.
Aspect 90. The method of any one of aspects 80-89, further comprising forming one or more barrier layers that enclose the quantum dot layer.
Aspect 91. The method of any one of aspects 80-90, wherein one or more of the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.
Aspect 92. The method of any one of aspects 80-91, wherein one or both of the plurality of first stabilized quantum dots and the plurality of second stabilized quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AISb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.
Aspect 93. The method of any one of aspects 80-92, wherein one or both of the plurality of first stabilized quantum dots and the plurality of second stabilized quantum dots comprise a core-shell structure.
Aspect 94. The method of any one of aspects 80-93, wherein forming the combination of the first polymer matrix and the second polymer matrix comprises mixing the first polymer matrix and the second polymer matrix such that the plurality first stabilized quantum dots are spontaneously phase separated from the plurality of second stabilized quantum dots.
Aspect 95. The method of any one of aspects 80-94, wherein the combination comprises a mixture.
Aspect 96. The method of any one of aspects 80-95, wherein the combination comprises a blend.

### Definitions

It is also to be understood that the terminology used herein is for the purpose of describing particular aspects only and is not intended to be limiting. As used in the specification and in the claims, the term "comprising" can include the embodiments "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional additives" means that the additional additives can or cannot be included and that the description includes compositions that both include and do not include additional additives.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included. As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application. Each of the materials disclosed herein are either commercially available and/or the methods for the production thereof are known to those of skill in the art. It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%. While "about" permits some tolerance, a person of ordinary skill in the art would read the specification in light of his knowledge and skill for guidance on the level of that tolerance, and be reasonably apprised to a reasonable degree the metes and bounds of the claims.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading may occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

As used herein, "quantum dots" or "QDs" (or QD, singular) refers to semiconductor nanometer structures that confine conduction band electrons, valence band holes and excitons in three spatial directions. This confinement can be attributed to the factors: electrostatic potential (generated by external electrodes, doping, stress or impurity), interface between two different semiconductor materials (for example in self-assembling quantum dots), semiconductor surface (such as semiconductor nanocrystal) or a combination of the above. QD's have a discrete quantized energy spectrum, and the corresponding wave function is located in the quantum dot in space, but extends across several crystal lattice periods. One quantum dot has a small amount of electrons (e.g., from about 1 to about 100), holes or hole-electron pairs, that is, the quantity of electricity it carries is an integral multiple of element of electric-charges. Since electrons and holes are quantumly confined, the continuous energy band structure is transformed into a discrete energy level structure with molecular characteristics, which can emit fluorescence after being stimulated.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation. The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which may be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "polymer" refers to a molecule having at least one repeating unit and can include copolymers and homopolymers. The polymers described herein can terminate in any suitable way. In some embodiments, the polymers can terminate with an end group that is independently chosen from a suitable polymerization initiator, -H, -OH, a substituted or unsubstituted (C₁-C₂₀)hydrocarbyl (e.g., (C₁-C₁₀)alkyl or (C₆-C₂₀)aryl) interrupted with 0, 1, 2, or 3 groups independently selected from -O-, substituted or unsubstituted -NH-, and -S-, a poly(substituted or unsubstituted (C₁-C₂₀)hydrocarbyloxy), and a poly(substituted or unsubstituted (C₁-C₂₀)hydrocarbylamino).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

All publications mentioned herein are incorporated herein by reference to disclose and describe the methods and/or materials in connection with which the publications are cited. The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A composition comprising:
a plurality of first stabilized quantum dots disposed in a first polymer, wherein the plurality of first stabilized quantum dots emit light in a first wavelength range upon excitation; and
a plurality of second stabilized quantum dots disposed in a second polymer, wherein the plurality of second stabilized quantum dots emit light in a second wavelength range upon excitation,
wherein the first polymer is combined with the second polymer such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a partial miscibility of the first polymer relative to the second polymer, wherein the partial miscibility of the first polymer relative to the second polymer is greater than 0% miscibility and less than 100% miscibility, and wherein the composition is capable of being extruded or coated.

2. The composition of claim 1, wherein the composition is disposed in a film.

3. The composition of claim 2, wherein the film does not include a barrier layer.

4. The composition of any one of claims 1-3, wherein the partial miscibility of the first polymer relative to the second polymer causes phase separation between portions of the plurality of first stabilized quantum dots and portions of the plurality of second stabilized quantum dots.

5. The composition of any one of claims 1-4, wherein the plurality of first stabilized quantum dots and the plurality of second stabilized quantum dots are disposed in a quantum dot layer adjacent to a light source, and wherein the light source comprises a blue light emitting source.

6. The composition of any one of claims 1-5, wherein one or more of the plurality of first stabilized quantum dots or the plurality of second stabilized quantum dots comprise one or more of the following:
an encapsulation around each of one or more of the plurality of first stabilized quantum dots or the plurality of second stabilized quantum dots, the encapsulation comprising an organic material or an inorganic material;
a plurality of ligands having a length of about 5 nanometers (nm) to about 200 nm;
a multi-shell structure;
a shell having a thickness of about 1 to about 20 nm;
a concentration-gradient quantum dot;
a core and a shell enclosing the core, the core and the shell comprising an alloy;
a structure having a lattice parameter tuned to reduce lattice stress;
a core having an alloy to match a lattice of a shell; and
an outer shell thickness and an inner shell thickness balanced to reduce lattice strain.

7. The composition of any one of claims 1-6, wherein one or more of the plurality of first stabilized quantum dots or the plurality of second stabilized quantum dots comprise a metal nanomaterial or an inorganic nanomaterial.

8. The composition of any one of claims 1-7, wherein one or more of the plurality of first stabilized quantum dots or the plurality of second stabilized quantum dots comprise a nanoparticle, a nanofiber, a nanorod, or a nanowire.

9. A composition comprising:
a plurality of first stabilized quantum dots disposed in a first polymer, wherein the plurality of first stabilized quantum dots emit light in a first wavelength range upon excitation; and
a plurality of second stabilized quantum dots disposed in a second polymer, wherein the plurality of second stabilized quantum dots emit light in a second wavelength range upon excitation,
wherein the first polymer is combined with the second polymer and a compatibilizer such that at least a portion of the plurality of first stabilized quantum dots are caused to be dispersed with at least a portion of the plurality of second stabilized quantum dots, and wherein a dispersion of the plurality of first stabilized quantum dots and the plurality of second stabilized quantum dots relative to each other is dependent on a partial miscibility of the first polymer relative to the second polymer and the compatibilizer, wherein the first polymer is immiscible relative to the second polymer without the compatibilizer, and wherein the composition is capable of being extruded or coated.

10. The composition of claim 9, wherein the partial miscibility of the first polymer relative to the second polymer and the compatibilizer causes phase separation between portions of the plurality of first stabilized quantum dots and portions of the plurality of second stabilized quantum dots.

11. The composition of any one of claims 9-10, wherein the plurality of first stabilized quantum dots and the plurality of second stabilized quantum dots are disposed in a quantum dot layer adjacent to a light source, and wherein the light source comprises a blue light emitting source.

12. The composition of any one of claims 9-11, wherein one or both of the plurality of first stabilized quantum dots and the plurality of second stabilized quantum dots are disposed in a layer by way of an extrusion process, a coating process, a printing process, a lithography process, or a polymerization process.

13. The composition of any one of claims 9-12, wherein the compatibilizer comprises a block copolymer comprising the first polymer and the second polymer.

14. The composition of any one of claims 9-13, wherein one or more of the plurality of first stabilized quantum dots or the plurality of second stabilized quantum dots comprise one or more of the following:
an encapsulation around each of one or more of the plurality of first stabilized quantum dots or the plurality of second stabilized quantum dots, the encapsulation comprising an organic material or an inorganic material;
a plurality of ligands having a length of about 5 nanometers (nm) to about 200 nm;
a multi-shell structure;
a shell having a thickness of about 1 to about 20 nm;
a concentration-gradient quantum dot;
a core and a shell enclosing the core, the core and the shell comprising an alloy;
a structure having a lattice parameter tuned to reduce lattice stress;
a core having an alloy to match a lattice of a shell; and
an outer shell thickness and an inner shell thickness balanced to reduce lattice strain.

15. An article comprising the composition of any one of claims 1-14, wherein the article comprises a display for an electronic device, wherein the electronic device is a mobile device, a tablet device, a gaming system, a handheld electronic device, a wearable device, a television, a desktop computer, or a laptop computer.
